# EUROPEAN PATENT SPECIFICATION

(11) **EP 3 073 281 B1**
(45) Date of publication and mention of the grant of the patent: **13.05.2020**
(21) Application number: 13897955.4
(22) Date of filing: 22.11.2013
(51) Int. Cl.: H02H 3/04, H02H 3/05, G01R 31/327, G01R 31/333

(54) **ELECTRONIC CIRCUIT BREAKER**
ELEKTRONISCHER SCHUTZSCHALTER
DISJONCTEUR DE CIRCUIT ÉLECTRONIQUE

(43) Date of publication of application: 28.09.2016
(73) Proprietor: Mitsubishi Electric Corporation, Tokyo 100-8310 (JP)
(72) Inventor: TAKIGAWA Yusuke, Tokyo 100-8310 (JP); NOMURA Toshimitsu, Tokyo 100-8310 (JP)
(74) Representative: Diehl & Partner GbR
(86) International application number: PCT/JP2013/081531
(87) International publication number: WO 2015/075815

(56) References cited:
- WO-A1-2013/175846
- JP-A- 2007 220 382
- JP-A- 2010 277 769
- JP-A- 2010 284 057
- US-B1- 6 421 214

## Description

### TECHNICAL FIELD

The present invention relates to electronic circuit breakers and, more particularly, relates to an electronic circuit breaker provided with a self-diagnostic function capable of periodically and automatically performing an operational test without interrupting power feed to loads.

### BACKGROUND ART

US 6,421,214 B1 discloses a self-testing arc fault or ground fault detector including an arc fault detecting circuitry and components. The detector includes a testing circuit which tests at least part of the circuitry and components and generates a recurring signal when the test completes successfully. If the test does not complete successfully, the signal is lost. This loss of signal is signaled by an indicator connected to the testing circuit.

As a conventional tripping operational test apparatus of an electronic circuit breaker, for example, one disclosed in Patent Document 1 is known. In the tripping operational test apparatus of the electronic circuit breaker disclosed in Patent Document 1, an operational test is performed such that the operational test apparatus is connected to the electronic circuit breaker and a tripping device of the electronic circuit breaker is driven to trip the electronic circuit breaker in a power feed stop state. The operation test apparatus includes: an incorporated battery; a triangular wave generation circuit that makes up an alternating current (AC) power source; a filter circuit which makes the output of the triangular wave generation circuit close to a sine wave; and a connection connector. Through the connection connector, a pseudo sine wave from the filter circuit and a direct current (DC) of the battery are supplied to the electronic circuit breaker. The pseudo sine wave serves as a signal corresponding to an overcurrent and a short circuit and/or ground fault accident of the electronic circuit breaker to be operationally tested; and the DC serves as the operating power source of an electronic circuit of the electronic circuit breaker.

Furthermore, when the operational test is erroneously performed on the electronic circuit breaker in a state where power feed is not stopped, the circuit breaker is tripped to generate an arc and it becomes dangerous. In order to prevent this, an interlock function that does not trip the circuit breaker in a power feed state is needed. However, in a conventional system, the operational test apparatus does not have a function that determines the power supply state; and accordingly, a problem exists in that an interlock function that forcibly stops the operational test during the power feed cannot be made up.

In dealing with such a problem, in an operational test apparatus of an overcurrent relay provided with a zero-phase current transformer that detects a ground fault and a tripping current circuit that is for driving a tripping device, there is proposed a test apparatus capable of performing an operational test even in a hot line state by disconnecting the connection between the tripping current circuit and the tripping device by an analog switch during the operation test so as not to operate the tripping device. (For example, see

### Patent Document 2.)

### PRIOR ART DOCUMENT

### PATENT DOCUMENT

Patent Document 1: Japanese Unexamined Patent Publication No. H09-166634
Patent Document 2: Japanese Unexamined Patent Publication No. 2000-261951

### SUMMARY OF THE INVENTION

### PROBLEMS TO BE SOLVED BY THE INVENTION

The conventional tripping operational test apparatus disclosed in Patent Document 1 has a problem that the power feed needs to be inevitably stopped in the case of inspection, load side facilities are forced to stop, and operational availability ratio lowers.

Furthermore, the apparatus disclosed in Patent Document 2 has a problem that the tripping device is not operated during the operational test; and accordingly, when a ground fault accident occurs during the operational test, a fault path cannot be separated and circuit protection serving as the original object cannot be achieved.

The present invention has been made to solve the above described problem, and an object of the present invention is to provide an electronic circuit breaker which the circuit breaker can be tripped in the case of the occurrence of an overcurrent and a short circuit and/or ground fault accident even during an operational test, a self-diagnostic function capable of periodically and automatically performing the operational test is further provided, and an operational availability ratio and reliability of facilities can be improved by performing the operational test from a stationary time.

### MEANS FOR SOLVING THE PROBLEMS

According to the present invention, there is provided an electronic circuit breaker including: a rectifier circuit which rectifies the secondary output of a current transformer that detects a current of a main circuit; and a constant voltage circuit which generates a constant voltage power source that is for driving a microcomputer and a tripping device of the circuit breaker by a current outputted from the rectifier circuit. The microcomputer includes: an analog/digital (A/D) conversion section to which a target measurement signal from the rectifier circuit is inputted; a threshold determination section which sets thresholds of an overcurrent, an instantaneous current, and a leakage current, the currents being to be flown to the main circuit, and determines whether or not the input signal to the A/D conversion section exceeds any of the thresholds; and a tripping signal output section which outputs a tripping signal to the tripping device when the threshold determination section determines that the input signal exceeds any of the thresholds of the overcurrent, the instantaneous current, and the leakage current. The electronic circuit breaker includes: a test signal output circuit which outputs a test signal that exceeds the set thresholds of the threshold determination section, the test signal being a sine wave signal that simulates the secondary output of the current transformer; a first changeover switch which is connected in series between the current transformer and the rectifier circuit and whose opening/closing time is controlled by a control signal from the microcomputer, whereby a signal to be inputted to the rectifier circuit is periodically switched between a signal outputted from the current transformer and the test signal outputted from the test signal output circuit; and a tripping output determination circuit which determines the operation state of the circuit breaker based on the output state of the tripping signal output section and the connection state of the first changeover switch.

### ADVANTAGEOUS EFFECT OF THE INVENTION

According to the electronic circuit breaker of the present invention, the circuit breaker can be tripped in the case of the occurrence of an overcurrent and a short circuit and/or ground fault accident even during an operational test and a self-diagnostic function capable of periodically and automatically performing the operational test is further provided, and an operational availability ratio and reliability of facilities can be improved by performing the operational test from a stationary time.

The foregoing and other objects, features, and advantageous effects of the present invention will become more apparent from detailed description in the following embodiments and description in the accompanying drawings.

### BRIEF DESCRIPTION OF THE DRAWINGS

FIG. 1 is a block diagram showing the configuration of an electronic circuit breaker in Embodiment 1 of the present invention;
FIG. 2 is a view showing a changeover timing chart of a first changeover switch in FIG. 1;
FIG. 3 is a block diagram showing the configuration of an electronic circuit breaker in Embodiment 2 of the present invention;
FIG. 4 is a block diagram showing the configuration of an electronic circuit breaker in Embodiment 3 of the present invention;
FIG. 5 is a block diagram showing the configuration of an electronic circuit breaker in Embodiment 4 of the present invention; and
FIG. 6 is a block diagram showing an external auxiliary apparatus in FIG. 5.

### MODE FOR CARRYING OUT THE INVENTION

Hereinafter, embodiments of the present invention will be described with reference to the drawings. Incidentally, the same reference numerals as those shown in the respective drawings represent the same or corresponding elements.

### Embodiment 1.

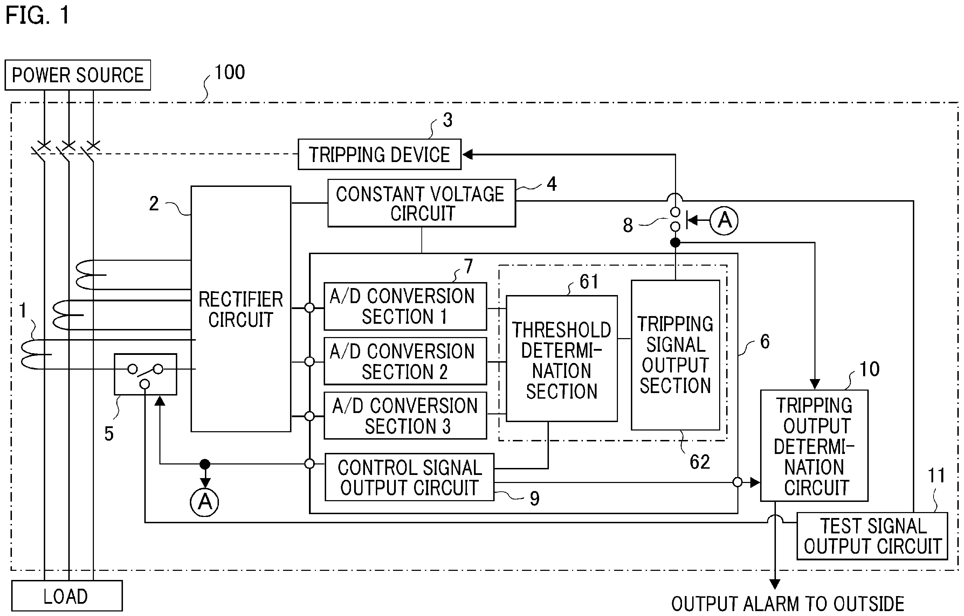

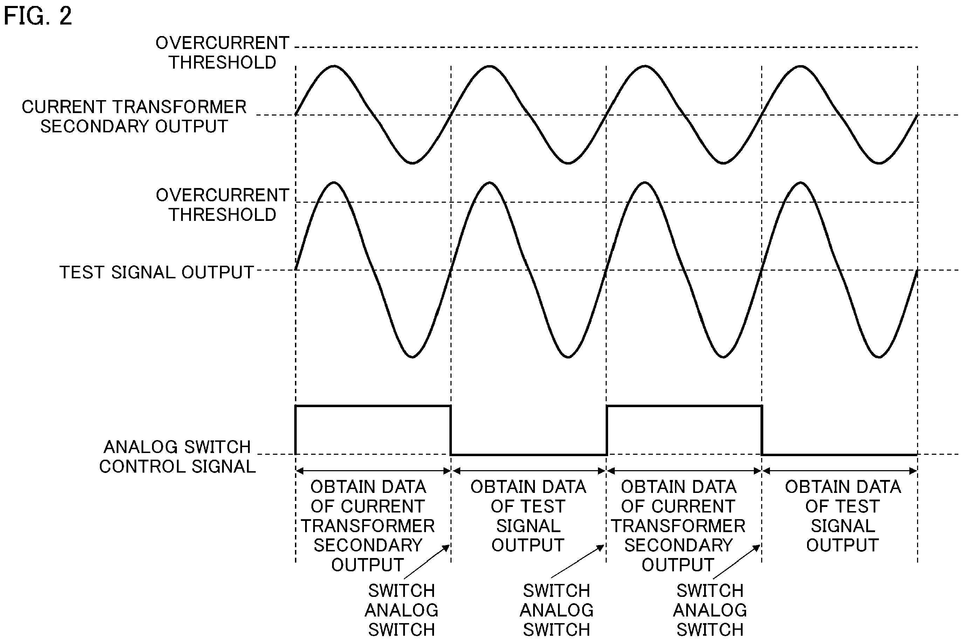

FIG. 1 is a block diagram showing the configuration of an electronic circuit breaker of Embodiment 1 of the present invention; and FIG. 2 is a view showing a changeover timing chart of a first changeover switch in FIG. 1.
In FIG. 1, a base (not shown in the drawing) of a circuit breaker 100 stores current transformers 1. When currents flow in main circuits, the current transformers 1 send output currents proportional to the flown currents to the secondary sides of the current transformers 1. The outputted currents are inputted to a constant voltage circuit 4 via a rectifier circuit 2; and the constant voltage circuit 4 generates a power source which is for driving an internal microcomputer 6 of the circuit breaker and a tripping device 3 of the circuit breaker. At the same time, the currents outputted from the rectifier circuit 2 are converted from current signals to voltage signals by the rectifier circuit 2 to be inputted to A/D conversion sections 7 of the microcomputer 6, respectively; and thus, current values flowing in the main circuits of the circuit breaker 100 are detected. A first changeover switch 5 is connected in series between the current transformer 1 and the rectifier circuit 2 and is constantly and periodically switched by a changeover switch control signal from a control signal output circuit 9 of the microcomputer 6, thereby performing changeover between a signal from the current transformer 1 and a test signal from a test signal output circuit 11.

FIG. 2 shows an example of the changeover timing of the first changeover switch 5.
The first changeover switch 5 detects the signal from the current transformer 1 when the control signal from the control signal output circuit 9 of the microcomputer 6 is an H level; and the microcomputer 6 obtains its data by the A/D conversion section 7.
When the control signal is an L level, the first changeover switch 5 switches to detect the signal from the test signal output circuit 11; and the microcomputer 6 obtains its data by the A/D conversion section 7. By constantly repeating this operation, the signal from the current transformer 1 and the test signal from the test signal output circuit 11 are alternately detected.

In a calculation section of the microcomputer 6, a threshold determination section 61 determines whether or not a value of the signal from the current transformer 1 inputted to the A/D conversion section 7 and a value of the test signal from the test signal output circuit 11 exceed predetermined thresholds of an overcurrent, an instantaneous current, a leakage current, the currents being to be flown to the main circuit; and if the values exceed the thresholds, a tripping signal is outputted from a tripping signal output section 62. A second changeover switch 8 different from the first changeover switch 5 is connected between from the tripping signal output section 62 to the tripping device 3.
Opening/closing of the second changeover switch 8 is performed by the control signal from the control signal output circuit 9 of the microcomputer 6, as in the first changeover switch 5. A tripping output determination circuit 10 is connected to the tripping signal output section 62; and the tripping output determination circuit 10 determines whether or not the circuit breaker 100 normally operates along with the control signal from the control signal output circuit 9.

More specifically, constantly, the test signal output circuit 11 sequentially and repeatedly outputs a signal that exceeds the thresholds of the threshold determination section 61 which sets the predetermined thresholds of the overcurrent, the instantaneous current, and the leakage current; and the tripping output determination circuit 10 determines as a normal operation while the first changeover switch 5 is connected to the test signal output circuit 11 and the tripping signal is outputted from tripping signal output section 62. Furthermore, when the tripping signal is not outputted from the tripping signal output section 62 although the first changeover switch 5 is connected to the test signal output circuit 11, or when the tripping signal is outputted from the tripping signal output section 62 although the first changeover switch 5 is not connected to the test signal output circuit 11, the tripping output determination circuit 10 determines as an abnormal operation and outputs an alarm to the outside of the circuit breaker 100.

An opening/closing time of the first changeover switch 5 is adjusted by the control signal from the control signal output circuit 9 of the microcomputer 6. Therefore, discrimination can be made whether the signal inputted to the A/D conversion section 7 of the microcomputer 6 is the signal proportional to the current of the main circuit, the current being outputted from the current transformer 1, or the test signal outputted from the test signal output circuit 11; and an erroneous operation of the circuit breaker 100 due to a mixture of the signals can be prevented.

Furthermore, the second changeover switch 8 is connected in series between the tripping signal output section 62 and the tripping device 3. The second changeover switch 8 is opened or closed by the control signal from the control signal output circuit 9 of the microcomputer 6, as in the first changeover switch 5; and when the tripping signal is the signal outputted from the current transformer 1, the second changeover switch 8 is closed and the tripping device 3 is driven to trip the circuit breaker. On the other hand, if the tripping signal is the signal outputted from the test signal output circuit 11, the second changeover switch 8 is opened not to operate the tripping device 3.

In either case, when the signal inputted to the A/D conversion section 7 exceeds the threshold of the threshold determination section 61, the tripping signal is outputted from the tripping signal output section 62; and thus, the tripping signal is fed back to the tripping output determination circuit 10 to determine whether or not the circuit breaker normally operates along with the control signal from the control signal output circuit 9 of the microcomputer 6.

According to the thus configured Embodiment 1 of the present invention, a path through which the test signal from the test signal output circuit 11 is inputted to the A/D conversion section 7 of the microcomputer 6 is the same as a path through which the secondary output from the current transformer 1 is inputted; and therefore, the operational test can be performed in a state near actual use condition and the configuration can be made without increasing the number of the A/D conversion sections 7 serving as input sections of the microcomputer 6.

Furthermore, the test signal is constantly inputted from the test signal output circuit 11 to the A/D conversion section 7 of the microcomputer 6 and the tripping signal is fed back from the tripping signal output section 62 to the tripping output determination circuit 10; and thus, a special tester is not needed with respect to the function from the current transformer 1 to the tripping signal output section 62, the operational test is automatically performed, and a self-diagnostic function can be imparted.

In addition, as the results of the operational test, when abnormality exists, the alarm is outputted from the tripping output determination circuit 10 to the outside and the abnormality can be informed to a user; and therefore, the abnormal circuit breaker is not continuously used and reliability of facilities is improved.

Further, according to the configuration of Embodiment 1, changeover of the first changeover switch 5 is constantly and periodically performed and the current of the main circuit is constantly detected by the current transformer 1; and therefore, even when an overcurrent, a short circuit and/or ground fault accident, and the like occur during the operational test, the circuit breaker 100 can be normally operated and load devices connected to the circuit breaker 100 can be protected.

### Embodiment 2.

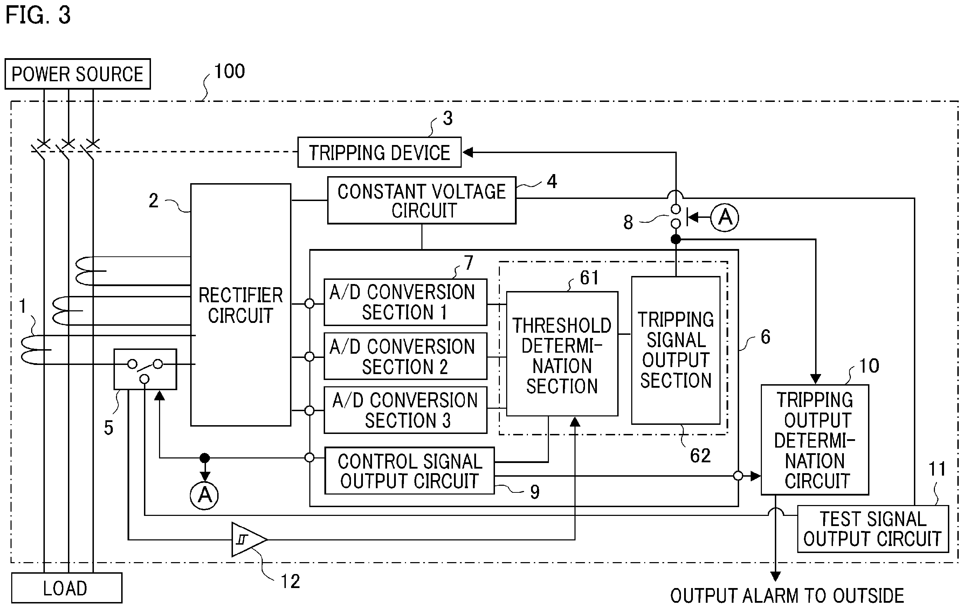

FIG. 3 is a block diagram showing the configuration of an electronic circuit breaker in Embodiment 2 of the present invention.
In Embodiment 1, since the output of the current transformer 1 and the test signal from the test signal output circuit 11 are periodically switched by the first changeover switch 5, there is a time zone where the current transformer 1 is not connected to the rectifier circuit 2 although a short time. When an instantaneous large current such as a short circuit and/or ground fault accident flows at the time zone, there is a possibility that the output from the current transformer 1 cannot be detected.
Embodiment 2 copes with such a case and, as shown in FIG. 3, a signal of the former stage of a first changeover switch 5 is inputted to a calculation section of a microcomputer via a Schmidt trigger circuit 12.

More specifically, when an instantaneous large current flows, output from the Schmidt trigger circuit 12 is inputted to a threshold determination section 61 of an instantaneous current regardless of opening/closing of the first changeover switch 5 to drive a tripping device 3 by a tripping signal from a tripping signal output section 62.

Incidentally, other configuration is the same as Embodiment 1 and therefore their description will be omitted.

According to this Embodiment 2, the Schmidt trigger circuit 12 is provided and the output from the current transformer 1 is detected regardless of the changeover timing of the first changeover switch 5 when the instantaneous large current flows; and therefore, even if a short circuit and/or ground fault accident occurs during the operational test, the circuit breaker 100 can be more reliably operated and load devices connected to the circuit breaker can be protected.

### Embodiment 3.

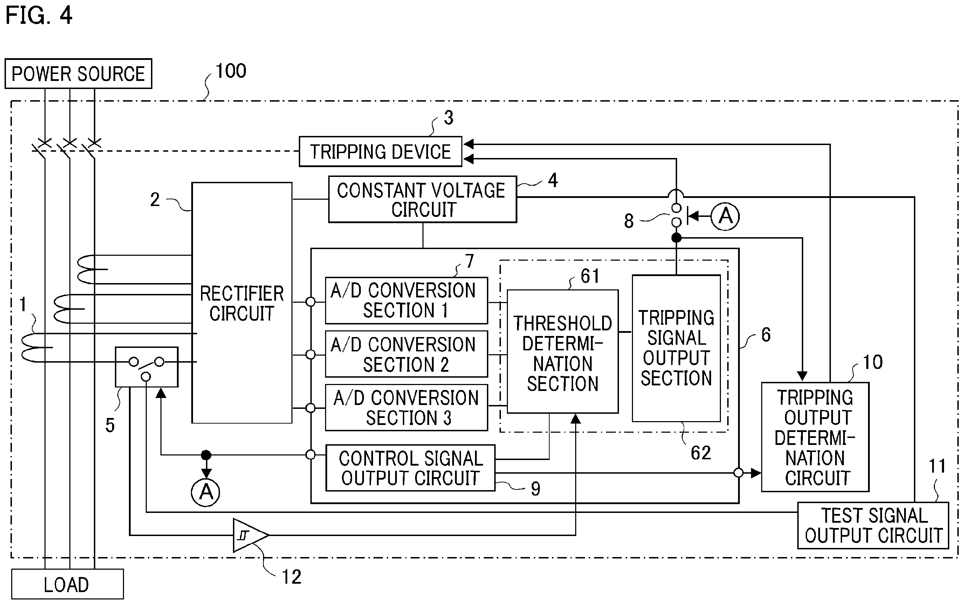

FIG. 4 is a block diagram showing the configuration of an electronic circuit breaker of Embodiment 3 of the present invention.
Embodiment 3 is one that the alarm is not outputted to the outside from the tripping output determination circuit 10 in Embodiment 2, but a trip instruction is outputted from a tripping output determination circuit 10 to a tripping device 3. Incidentally, other configuration is the same as Embodiment 2 and therefore their description will be omitted.

According to Embodiment 3, when the tripping output determination circuit 10 determines as an abnormal operation, the tripping output determination circuit 10 outputs the trip instruction to the tripping device 3 to operate the circuit breaker 100; and therefore, an abnormally operated part of the circuit breaker 100 is automatically and immediately paralleled off, it is possible to avoid a state where load devices connected to the circuit breaker cannot be protected, and reliability of facilities can be further improved.

### Embodiment 4.

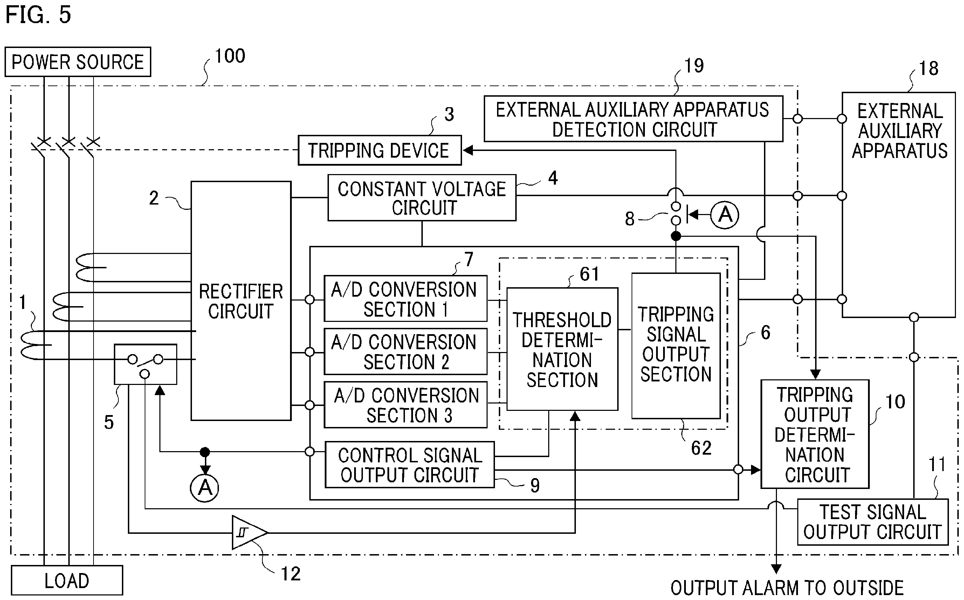

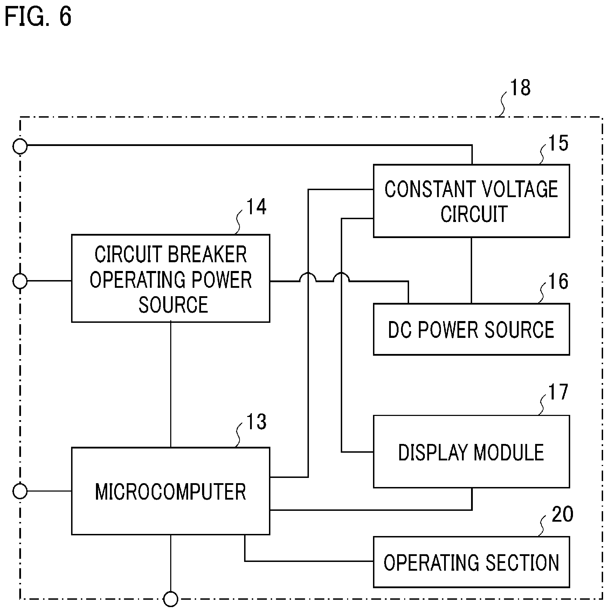

FIG. 5 is a block diagram showing the configuration of an electronic circuit breaker in Embodiment 4 of the present invention; and FIG. 6 is a block diagram showing the configuration of an external auxiliary apparatus shown in FIG. 5.

In the above-mentioned configuration of Embodiments 1 to 3, the power source that is for driving all circuits is obtained from the current transformers 1; and accordingly, the operational test cannot be performed in a state where a current does not flow in the main circuit.
Embodiment 4 is one that performs control of a test signal output circuit by not only a circuit breaker but also by an external auxiliary apparatus in Embodiment 2.

In FIG. 5 and FIG. 6, separately from a circuit breaker 100, an external auxiliary apparatus 18 is an independent housing which includes: a DC power source 16, a constant voltage circuit 15, a circuit breaker operating power source 14, a microcomputer 13, and a display module 17 and is an apparatus which can be mounted to any circuit breaker according to user's intention by making it mountable. In this case, the DC power source 16 is a movable power source such as a dry battery and generates a power source which drives the microcomputer 13 and the display module 17 by the constant voltage circuit 15. Furthermore, the constant voltage circuit 15 is connected to the external auxiliary apparatus detection circuit 19 of the circuit breaker to recognize that the external auxiliary apparatus 18 is connected to the internal microcomputer 6 of the circuit breaker.

When a current flows in a main circuit and the operational test is automatically performed, information is transmitted from the internal microcomputer 6 of the circuit breaker to the internal microcomputer 13 of the external auxiliary apparatus and the display module 17 displays operation states such as a current value of the main circuit and the determination results of normality/abnormality of a self-diagnostic function. When the user intentionally performs the operational test via the external auxiliary apparatus 18 in a state where the current does not flow in the main circuit, the operating section 20 and the display module 17 determine a test current value and the microcomputer 13 controls such that the test signal output circuit 11 outputs a test signal corresponding to the test current value. When the test signal exceeds the thresholds of the threshold determination section 61, a power source that drives the tripping device 3 is supplied from the circuit breaker operating power source 14 to trip the circuit breaker. Of course, the power source 16 of the external auxiliary apparatus 18 is not limited to a DC power source such as a dry battery, but the power source 16 may be even a configuration that is provided with an AC/DC conversion circuit in the external auxiliary apparatus 18 to drive by applying an AC voltage from the outside.

According to Embodiment 4, in the operational test when the external auxiliary apparatus 18 is connected and the current does not flow in the main circuit, the tripping device 3 is driven by the circuit breaker operating power source 14 provided in an external auxiliary apparatus 18; and therefore, even a mechanical operation that the tripping device 3 normally operates to trip the circuit breaker can be confirmed. Furthermore, instructions can be given so as to output the test signal at optional timing from the microcomputer 13 of the external auxiliary apparatus 18 to the test signal output circuit 11; and therefore, the operational test can be freely performed at a periodic inspection time when facilities seem to be stopped.

### INDUSTRIAL APPLICABILITY

The present invention relates to an electronic circuit breaker provided with a self-diagnostic function capable of periodically and automatically performing an operational test without interrupting power feed to loads and is useful as a circuit breaker which improves an operational availability ratio and reliability of facilities.

### DESCRIPTION OF REFERENCE NUMERALS

1: Current transformer,
2: Rectifier circuit,
3: Tripping device,
4: Constant voltage circuit,
5: First changeover switch,
6: Internal microcomputer of circuit breaker,
7: A/D conversion section,
8: Second changeover switch,
9: Control signal output circuit,
10: Tripping output determination circuit,
11: Test signal output circuit,
12: Schmidt trigger circuit,
13: Internal microcomputer of external auxiliary apparatus,
14: Circuit breaker operating power source,
15: Constant voltage circuit,
16: DC power source,
17: Display module,
18: External auxiliary apparatus,
19: External auxiliary apparatus detection circuit,
20: Operating section,
61: Threshold determination section,
62: Tripping signal output section,
100: Circuit breaker

## Claims

1. An electronic circuit breaker (100) comprising:
a rectifier circuit (2) which rectifies the secondary output of a current transformer (1) that detects a current of a main circuit; and
a constant voltage circuit (4) which generates a constant voltage power source that is for driving a microcomputer (6) and a tripping device (3) of said circuit breaker (100) by a current outputted from said rectifier circuit (2),
said microcomputer (6) including:
an A/D conversion section (7) to which a target measurement signal from said rectifier circuit (2) is inputted;
a threshold determination section (61) which sets thresholds of an overcurrent, an instantaneous current, and a leakage current, the currents being to be flown to the main circuit, and determines whether or not the input signal to said A/D conversion section (7) exceeds any of the thresholds; and
a tripping signal output section (62) which outputs a tripping signal to said tripping device (3) when said threshold determination section (61) determines that the input signal exceeds any of the thresholds of the overcurrent, the instantaneous current, and the leakage current,
wherein said electronic circuit breaker (100) comprises:
a test signal output circuit (11) which outputs a test signal that exceeds the set thresholds of said threshold determination section (61), the test signal being a sine wave signal that simulates the secondary output of said current transformer (1);
a first changeover switch (5) which is connected in series between said current transformer (1) and said rectifier circuit (2) and whose opening/closing time is controlled by a control signal from said microcomputer (6), whereby a signal to be inputted to said rectifier circuit (2) is periodically switched between a signal outputted from said current transformer (1) and the test signal outputted from said test signal output circuit (11); and
a tripping output determination circuit (10) which determines the operation state of said circuit breaker (100) based on the output state of said tripping signal output section (62) and the connection state of said first changeover switch (5).

2. The electronic circuit breaker (100) according to claim 1, wherein the opening/closing time of said first changeover switch (5) is controlled by the control signal of said internal microcomputer (6) of said circuit breaker (100), whereby discrimination is made whether the output of said rectifier circuit (2) is a secondary output signal from said current transformer (1) or the test signal from said test signal output circuit (11).

3. The electronic circuit breaker (100) according to claim 2,
further comprising a second changeover switch (8) which is provided in series between from said tripping signal output section (62) to said tripping device (3) and is controlled to open or close by the control signal from said microcomputer (6) as in said first changeover switch (5), and
wherein said second changeover switch (8) is closed to trip said circuit breaker (100) by driving said tripping device (3) when the tripping signal outputted from said tripping signal output section (62) is based on the signal outputted from said current transformer (1); and
said second changeover switch (8) is opened not to operate said tripping device (3) when the tripping signal outputted from said tripping signal output section (62) is based on the test signal outputted from said test signal output circuit (11).

4. The electronic circuit breaker (100) according to claim 3,
further comprising a Schmitt trigger circuit (12) connected to said first changeover switch (5), and
wherein a signal of said first changeover switch (5) is inputted to said threshold determination section (61) of said microcomputer (6) via said Schmitt trigger circuit (12).

5. The electronic circuit breaker (100) according to any one of claim 1 to claim 4,
wherein the tripping signal from said tripping signal output section (62) is fed back to said tripping output determination circuit (10), whereby said circuit breaker (100) itself has a self-diagnostic function that determines the operation state thereof; and
said tripping output determination circuit (10) outputs an alarm to the outside when operation abnormality is recognized.

6. The electronic circuit breaker (100) according to any one of claim 1 to claim 4,
wherein the tripping signal from said tripping signal output section (62) is fed back to said tripping output determination circuit (10), whereby said circuit breaker (100) itself has a self-diagnostic function that determines the operation state thereof; and
said tripping output determination circuit (10) outputs a tripping signal to said tripping device (3) to automatically trip when operation abnormality is recognized.

7. The electronic circuit breaker (100) according to any one of claim 1 to claim 4, further comprising:
an external auxiliary apparatus (18) which is connected to said circuit breaker (100) and includes a circuit breaker operating power source (14), a display section (17), and a microcomputer (13) that controls the output of said test signal output circuit (11); and
an external auxiliary apparatus detection circuit (19) which is provided in the inside of said circuit breaker (100) and detects the connection state of
said external auxiliary apparatus (18), and
wherein when a current flows in the main circuit, the operation state of said circuit breaker (100) is displayed in said display section (17) of said external auxiliary apparatus (18); and
when a current does not flow in the main circuit, an operating power source is supplied from said circuit breaker operating power source (14) to said tripping device (3) and said test signal output circuit (11) is driven by said microcomputer (13) to input the test signal to said circuit breaker (100), thereby enabling said circuit breaker (100) to perform a trip operation.

## Patentansprüche

1. Elektronischer Leistungsschalter (100), aufweisend:
eine Gleichrichterschaltung (2), die den sekundären Ausgang eines Stromwandlers (1), der einen Strom eines Hauptstromkreises erfasst, gleichrichtet; und
eine Konstantspannungsschaltung (4), die mittels eines von der Gleichrichterschaltung (2) ausgegebenen Stroms eine Konstantspannungsstromquelle bereitstellt, die zum Betreiben eines Mikrocomputers (6) und einer Auslösevorrichtung (3) des Leistungsschalters (100) dient,
wobei der Mikrocomputer (6) umfasst:
einen A/D-Wandlerabschnitt (7), in den von der Gleichrichterschaltung (2) ein Messzielsignal eingegeben wird;
einen Schwellenwert-Bestimmungsabschnitt (61), der Schwellenwerte für einen Überstrom, einen Momentanstrom und einen Leckstrom festlegt, wobei die Ströme im Hauptstromkreis fließen müssen, und bestimmt, ob das Eingangssignal zu dem A/D-Wandlerabschnitt (7) irgendeinen der Schwellenwerte überschreitet, oder nicht; und
einen Auslösesignal-Ausgabeabschnitt (62), der ein Auslösesignal an die Auslösevorrichtung (3) ausgibt, wenn der Schwellenwert-Bestimmungsabschnitt (61) feststellt, dass das Eingangssignal einen der Schwellenwerte für den Überstrom, den Momentanstrom oder den Leckstrom überschreitet,
wobei der elektronische Leistungsschalter (100) weiter aufweist:
eine Prüfsignal-Ausgabeschaltung (11), die ein Prüfsignal ausgibt, das die eingestellten Schwellenwerte des Schwellenwert-Bestimmungsabschnitts (61) überschreitet, wobei das Prüfsignal ein Sinussignal ist, das den sekundären Ausgang des Stromwandlers (1) simuliert;
einen ersten Umschalter (5), der zwischen dem Stromwandler (1) und der Gleichrichterschaltung (2) in Reihe geschaltet ist und dessen Öffnungs-/Schließzeit durch ein Steuersignal des Mikrocomputers (6) gesteuert wird,
wobei ein in die Gleichrichterschaltung (2) einzugebendes Signal periodisch zwischen einem von dem Stromwandler (1) ausgegebenen Signal und dem von der Prüfsignal-Ausgabeschaltung (11) ausgegebenen Prüfsignal umgeschaltet wird; und
eine Auslöseausgabe-Bestimmungsschaltung (10), die den Betriebszustand des Leistungsschalters (100) auf der Grundlage des Ausgangszustands des Auslösesignal-Ausgabeabschnitts (62) und des Verbindungszustands des ersten Umschalters (5) bestimmt.

2. Elektronischer Leistungsschalter (100) nach Anspruch 1, wobei die Öffnungs-/Schließzeit des ersten Umschalters (5) durch das Steuersignal des internen Mikrocomputers (6) des Leistungsschalters (100) gesteuert wird, wodurch unterschieden wird, ob das Ausgangssignal der Gleichrichterschaltung (2) ein sekundäres Ausgangssignal des Stromwandlers (1) oder das Prüfsignal der Prüfsignal-Ausgabeschaltung (11) ist.

3. Elektronischer Leistungsschalter (100) nach Anspruch 2,
ferner aufweisend einen zweiten Umschalter (8), der in Reihe zwischen dem Auslösesignal-Ausgabeabschnitt (62) und der Auslösevorrichtung (3) angeordnet ist und zum Öffnen oder Schließen wie der erste Umschalter (5) durch das Steuersignal des Mikrocomputers (6) gesteuert wird, und
wobei der zweite Umschalter (8) geschlossen wird, um den Leistungsschalter (100) durch Betätigen der Auslösevorrichtung (3) auszulösen, wenn das von dem Auslösesignal-Ausgabeabschnitt (62) ausgegebene Auslösesignal auf dem von dem Stromwandler (1) ausgegebenen Signal basiert; und
der zweite Umschalter (8) geöffnet wird, um die Auslösevorrichtung (3) nicht zu betätigen, wenn das von dem Auslösesignal-Ausgabeabschnitt (62) ausgegebene Auslösesignal auf dem von der Prüfsignal-Ausgabeschaltung (11) ausgegebenen Prüfsignal basiert.

4. Elektronischer Leistungsschalter (100) nach Anspruch 3,
weiter aufweisend eine Schmitt-Trigger-Schaltung (12), die mit dem ersten Umschalter (5) verbunden ist, und
wobei ein Signal des ersten Umschalters (5) über die Schmitt-Trigger-Schaltung (12) in den Schwellenwert-Bestimmungsabschnitt (61) des Mikrocomputers (6) eingegeben wird.

5. Elektronischer Leistungsschalter (100) nach einem der Ansprüche 1 bis 4,
wobei das Auslösesignal des Auslösesignal-Ausgabeabschnitts (62) zu der Auslöseausgabe-Bestimmungsschaltung (10) zurückgeführt wird, wodurch der Leistungsschalter (100) selbst eine Selbstdiagnosefunktion hat, die seinen Betriebszustand bestimmt; und
wobei die Auslöseausgabe-Bestimmungsschaltung nach außen einen Alarm ausgibt, wenn eine Anomalie des Betriebs erkannt wird.

6. Elektronischer Leistungsschalter (100) nach einem der Ansprüche 1 bis 4,
wobei das Auslösesignal des Auslösesignal-Ausgabeabschnitts (62) zu der Auslöseausgabe-Bestimmungsschaltung (10) zurückgeführt wird, wodurch der Leistungsschalter (100) selbst eine Selbstdiagnosefunktion besitzt, die seinen Betriebszustand bestimmt; und
wobei die Auslöseausgabe-Bestimmungsschaltung (10) ein Auslösesignal an die Auslösevorrichtung (3) ausgibt, um automatisch auszulösen, wenn eine Anomalie des Betriebs erkannt wird.

7. Elektronischer Leistungsschalter (100) nach einem der Ansprüche 1 bis 4, weiter aufweisend:
eine externe Hilfsvorrichtung (18), die mit dem Leistungsschalter (100) verbunden ist und eine Leistungsschalter-Betriebsstromquelle (14), einen Anzeigeabschnitt (17) und einen Mikrocomputer (13), der die Ausgabe der Prüfsignal-Ausgabeschaltung (11) steuert, aufweist; und
eine externe Hilfsvorrichtung-Erfassungsschaltung (19), die im Inneren des Leistungsschalters (100) angeordnet ist und den Verbindungszustand der externen Hilfsvorrichtung (18) erfasst, und
wobei, wenn ein Strom im Hauptstromkreis fließt, der Betriebszustand des Leistungsschalters (100) in dem Anzeigeabschnitt (17) der externen Hilfsvorrichtung (18) angezeigt wird; und
wobei, wenn kein Strom im Hauptstromkreis fließt, der Auslösevorrichtung (3) von der Leistungsschalter-Betriebsstromquelle (14) ein Betriebsstrom zugeführt, und die Prüfsignal-Ausgabeschaltung (11) durch den Mikrocomputer (13) betätigt wird, um in den Leistungsschalter (100) das Prüfsignal einzugeben, wodurch der Leistungsschalter (100) dazu in die Lage versetzt wird, einen Auslösevorgang durchzuführen.

## Revendications

1. Disjoncteur électronique (100) comprenant:
un circuit redresseur (2) qui redresse la sortie secondaire d'un transformateur de courant (1) qui détecte un courant d'un circuit principal; et
un circuit de tension constante (4) qui génère une source d'alimentation de tension constante qui est destinée à piloter un microcalculateur (6) et un dispositif de déclenchement (3) dudit disjoncteur (100) par un courant délivré en sortie dudit circuit redresseur (2),
ledit microcalculateur (6) incluant:
une section de conversion A/D (7) à laquelle un signal de mesure cible provenant dudit circuit redresseur (2) est appliqué en entrée;
une section de détermination de seuil (61) qui fixe des seuils d'une surintensité, d'un courant instantané et d'un courant de fuite, les courants étant destinés à circuler jusqu'au circuit principal, et détermine si le signal d'entrée de ladite section de conversion A/D (7) dépasse ou non l'un quelconque des seuils; et
une section de sortie de signal de déclenchement (62) qui délivre en sortie un signal de déclenchement audit dispositif de déclenchement (3) lorsque ladite section de détermination de seuil (61) détermine que le signal d'entrée dépasse l'un quelconque des seuils de la surintensité, du courant instantané et du courant de fuite,
dans lequel ledit disjoncteur électronique (100) comprend:
un circuit de sortie de signal d'essai (11) qui délivre en sortie un signal d'essai qui dépasse les seuils fixés de ladite section de détermination de seuil (61), le signal d'essai étant un signal d'onde sinusoïdale qui simule la sortie secondaire dudit transformateur de courant (1);
un premier commutateur inverseur (5) qui est connecté en série entre ledit transformateur de courant (1) et ledit circuit redresseur (2) et dont le temps d'ouverture/de fermeture est commandé par un signal de commande provenant dudit microcalculateur (6), ce par quoi un signal à appliquer en entrée dudit circuit redresseur (2) est périodiquement commuté entre un signal délivré en sortie dudit transformateur de courant (1) et le signal d'essai délivré en sortie dudit circuit de sortie de signal d'essai (11); et
un circuit de détermination de sortie de déclenchement (10) qui détermine l'état de fonctionnement dudit disjoncteur (100) sur la base de l'état de sortie de ladite section de sortie de signal de déclenchement (62) et l'état de connexion dudit premier commutateur inverseur (5).

2. Disjoncteur électronique (100) selon la revendication 1, dans lequel le temps d'ouverture/de fermeture dudit premier commutateur inverseur (5) est commandé par le signal de commande dudit microcalculateur interne (6) dudit disjoncteur (100), en sorte qu'une discrimination est faite de si la sortie dudit circuit redresseur (2) est un signal de sortie secondaire provenant dudit transformateur de courant (1) ou le signal d'essai provenant dudit circuit de sortie de signal d'essai (11).

3. Disjoncteur électronique (100) selon la revendication 2,
comprenant en outre un second commutateur inverseur (8) qui est agencé en série entre de ladite section de sortie de signal de déclenchement (62) audit dispositif de déclenchement (3) et est commandé pour s'ouvrir ou se fermer par le signal de commande provenant dudit microcalculateur (6) comme dans ledit premier commutateur inverseur (5), et
dans lequel ledit second commutateur inverseur (8) est fermé pour déclencher ledit disjoncteur (100) en pilotant ledit dispositif de déclenchement (3) lorsque le signal de déclenchement délivré en sortie de ladite section de sortie de signal de déclenchement (62) est basé sur le signal délivré en sortie dudit transformateur de courant (1); et
ledit second commutateur inverseur (8) est ouvert pour ne pas faire fonctionner ledit dispositif de déclenchement (3) lorsque le signal de déclenchement délivré en sortie de ladite section de sortie de signal de déclenchement (62) est basé sur le signal d'essai délivré en sortie dudit circuit de sortie de signal d'essai (11).

4. Disjoncteur électronique (100) selon la revendication 3,
comprenant en outre un circuit de déclenchement de Schmitt (12) connecté dans dudit premier commutateur inverseur (5), et
dans lequel un signal de dudit premier commutateur inverseur (5) est appliqué à l'entrée de ladite section de détermination de seuil (61) dudit microcalculateur (6) via ledit circuit de déclenchement de Schmitt (12).

5. Disjoncteur électronique (100) selon l'une quelconque des revendications 1 à 4, dans lequel le signal de déclenchement provenant de ladite section de sortie de signal de déclenchement (62) est réinjecté dans ledit circuit de détermination de sortie de déclenchement (10), en sorte que ledit disjoncteur (100) lui-même a une fonction d'auto diagnostic qui détermine l'état de fonctionnement de celui-ci; et ledit circuit de détermination de sortie de déclenchement (10) délivre en sortie une alarme à l'extérieur lorsqu'une anomalie de fonctionnement est reconnue.

6. Disjoncteur électronique (100) selon l'une quelconque des revendications 1 à 4, dans lequel le signal de déclenchement provenant de ladite section de sortie de signal de déclenchement (62) est réinjecté dans ledit circuit de détermination de sortie de déclenchement (10), en sorte que ledit disjoncteur (100) lui-même a une fonction d'auto diagnostic qui détermine l'état de fonctionnement de celui-ci; et ledit circuit de détermination de sortie de déclenchement (10) délivre en sortie un signal de déclenchement audit dispositif de déclenchement (3) pour se déclencher automatiquement lorsqu'une anomalie de fonctionnement est reconnue.

7. Disjoncteur électronique (100) selon l'une quelconque des revendications 1 à 4, comprenant en outre:
un appareil auxiliaire externe (18) qui est connecté audit disjoncteur (100) et inclut une source d'alimentation de fonctionnement de disjoncteur (14), une section d'affichage (17) et un microcalculateur (13) qui commande la sortie dudit circuit de sortie de signal d'essai (11); et
un circuit de détection d'appareil auxiliaire externe (19) qui est agencé à l'intérieur dudit disjoncteur (100) et détecte l'état de connexion dudit appareil auxiliaire externe (18), et
dans lequel lorsqu'un courant circule dans le circuit principal, l'état de fonctionnement dudit disjoncteur (100) est affiché dans ladite section d'affichage (17) dudit appareil auxiliaire externe (18); et
lorsqu'un courant ne circule pas dans le circuit principal, une source d'alimentation de fonctionnement est fournie à partir de ladite source d'alimentation de fonctionnement de disjoncteur (14) audit dispositif de déclenchement (3) et ledit circuit de sortie de signal d'essai (11) est piloté par ledit microcalculateur (13) pour appliquer en entrée le signal d'essai audit disjoncteur (100), en permettant ainsi audit disjoncteur (100) d'exécuter une opération de déclenchement.
